# FASCICULE DE BREVET EUROPEEN

(11) **EP 3 261 124 B1**
(45) Date de publication et mention de la délivrance du brevet: **19.08.2020**
(21) Numéro de dépôt: 17176724.7
(22) Date de dépôt: 19.06.2017
(51) Int. Cl.: H01L 29/66, H01L 29/786, H01L 21/8238, H01L 21/8234, H01L 21/311

(54) **PROCÉDÉ DE FORMATION DES ESPACEURS D'UNE GRILLE D'UN TRANSISTOR**
VERFAHREN ZUR BILDUNG VON ABSTANDHALTERN EINES GATES EINES TRANSISTORS
METHOD FOR FORMING SPACERS OF A TRANSISTOR GATE

(30) Priorité: 20.06.2016 FR 1655739
(43) Date de publication de la demande: 27.12.2017
(73) Titulaire: Commissariat à l'Energie Atomique et aux Energies Alternatives, 75015 Paris (FR)
(72) Inventeur: POLLET, Olivier, 38000 Grenoble (FR); GARCIA-BARROS, Maxime, 94200 Ivry sur Seine (FR); POSSEME, Nicolas, 38360 Sassenage (FR)
(74) Mandataire: Hautier, Nicolas

(56) Documents cités:
- US-A1- 2003 017 686
- US-A1- 2013 037 919
- US-A1- 2014 179 107
- US-A1- 2014 273 292

## Description

### DOMAINE TECHNIQUE DE L'INVENTION

La présente invention concerne en général les transistors à effet de champs (FET) et plus particulièrement la réalisation des espaceurs de grille des transistors de type métal-oxyde-semiconducteur (MOSFET).

### ÉTAT DE LA TECHNIQUE

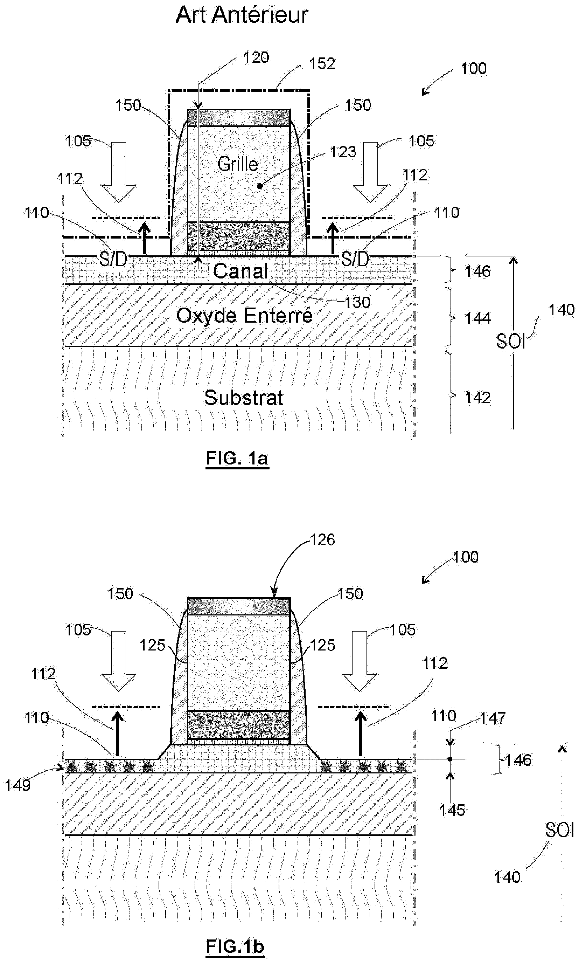

La **figure 1a** est une vue en coupe d'un exemple de transistor 100 en cours de réalisation. On y retrouve les zones de source et de drain 110, globalement désignées zones source/drain, puisqu'elles sont très généralement parfaitement symétriques et peuvent jouer les deux rôles en fonction des polarisations électriques qui sont appliquées au transistor. La grille est classiquement constituée d'un empilement de couches 120 dont une grande partie est le plus souvent constituée de silicium polycristallin 123. La formation des zones de source et drain se fait typiquement par implantation ionique 105 de dopants dans les zones 110, la grille 120 servant de masque, empêchant ainsi le dopage de la zone du transistor MOSFET dans laquelle, en fonction des tensions appliquées sur la grille, va pouvoir se développer le canal 130 de conduction entre source et drain.

Sur cet exemple illustré le substrat 140 est de type silicium sur isolant, (SOI). Il comprend une fine couche superficielle de silicium monocristallin 146 reposant sur une couche continue d'oxyde de silicium 144, dit oxyde enterré ou encore BOX, acronyme de l'anglais « buried oxide layer ». La solidité et la rigidité mécanique de l'ensemble sont assurées par la couche 142 qui constitue le corps du substrat SOI, souvent qualifié du vocable anglais de « bulk ».

Les espaceurs 150, typiquement faits de nitrure de silicium (SiN), vont permettre en particulier la mise en oeuvre d'une technique dite de « Source et Drain surélevés ». Pour pouvoir maintenir de faibles résistances électriques d'accès aux électrodes de source et de drain, en dépit de la réduction de taille des transistors, il a fallu en effet augmenter leur section. Ceci est obtenu par épitaxie sélective des zones source/drain 110. Au cours de cette opération on va faire croître 112 localement la couche initiale de silicium monocristallin 146. Il faut alors protéger les zones de grilles pour empêcher la croissance de se faire également à partir du silicium polycristallin 123 de la grille. C'est, entre autres, le rôle des espaceurs que d'assurer cette fonction. Ils assurent également un rôle de préservation de la grille lors de la siliciuration des contacts (non représentée) qui est ensuite effectuée dans le même but afin de diminuer la résistance série d'accès aux électrodes du transistor.

La formation des espaceurs 150 est devenue une étape cruciale de formation des transistors qui atteignent désormais des dimensions qui se mesurent couramment en nanomètres (nm = 10⁻⁹ mètres) et qui sont globalement de tailles décananométriques. La réalisation des espaceurs se fait sans faire intervenir aucune opération de photogravure. Ils sont auto alignés sur la grille 120 à partir du dépôt d'une couche uniforme de nitrure de silicium 152 (SiN) qui subit ensuite une gravure très fortement anisotrope. Cette gravure du SiN attaque préférentiellement les surfaces horizontales, c'est-à-dire toutes les surfaces qui sont parallèles au plan du substrat SOI. Elle ne laisse en place, imparfaitement, que les parties verticales de la couche 152, celles sensiblement perpendiculaires au plan du substrat, afin d'obtenir en pratique les motifs 150 dont la forme idéale serait bien souvent rectangulaire.

Avec les solutions connues, la réduction de taille des transistors rend très délicate l'obtention d'espaceurs jouant pleinement leur rôle d'isolation et n'induisant pas de défauts dans la réalisation de transistors à partir de substrats SOI. En effet, il a été constaté que plusieurs types de défaut tels que ceux mentionnés ci-dessous apparaissent lors de la gravure des espaceurs en utilisant l'un ou l'autre des procédés connus de gravure anisotrope.

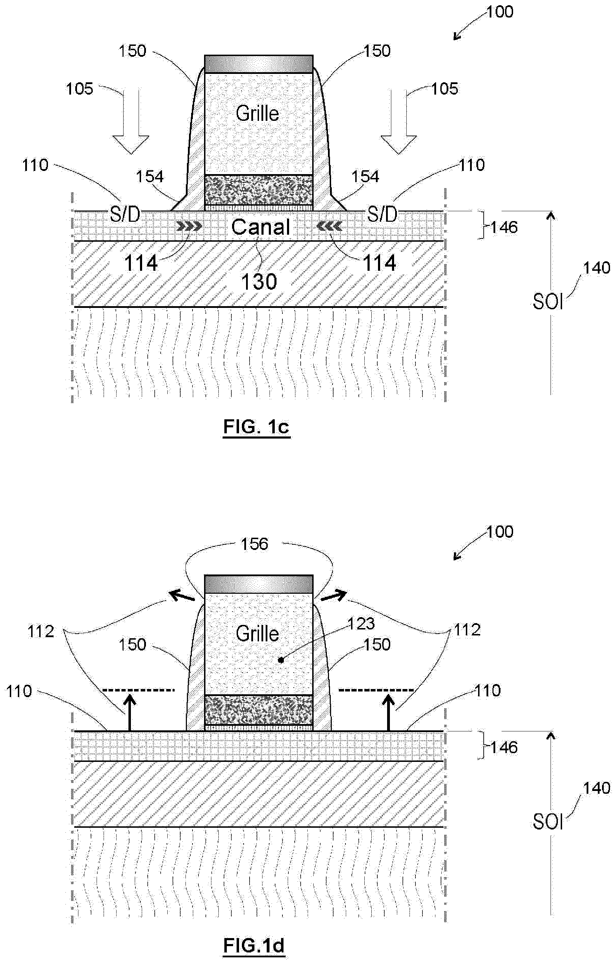

Les **figures 1b**, **1c et 1d** illustrent chacune un type de défaut observé.

On utilise notamment un type de gravure qui est dite « sèche » et qui se met en oeuvre à l'aide d'un procédé qui est le plus souvent désigné par son acronyme RIE, de l'anglais « reactive-ion eching », c'est-à-dire : « gravure ionique réactive ». Il s'agit d'un procédé de gravure dans lequel on forme, dans une enceinte confinée, un plasma qui réagit physiquement et chimiquement avec la surface de la tranche à graver. Dans le cas de la gravure d'une couche de nitrure de silicium, qui est comme on l'a vu un matériau usuel pour la réalisation des espaceurs, le gaz réactif est typiquement le fluorure de méthyle (CH3F) que l'on fait réagir avec le matériau à graver en introduisant également du dioxygène (O2). On forme ainsi un plasma de gravure basé sur la chimie du fluor et souvent désigné par ses constituants : CH3F/O2/He.

L'avantage de ce type de gravure est qu'elle est assez anisotrope et permet de contrôler suffisamment le profil des espaceurs 150 même si l'on ne peut pas obtenir en pratique la forme rectangulaire idéale. L'inconvénient de ce type de gravure est que la sélectivité d'attaque du silicium sous-jacent est cependant limitée. La sélectivité, c'est-à-dire le rapport des vitesses de gravure entre le nitrure de silicium et le silicium est de l'ordre de 10 et peut atteindre 15 au maximum en fonction des conditions de formation du plasma (le nitrure est gravé 10 à 15 fois plus vite que le silicium).

On utilise aussi des gravures dites « humides » à base d'acide phosphorique (H3PO4) qui ne permettent pas de contrôler le profil des espaceurs puisque la gravure est essentiellement isotrope dans ce cas. On notera ici que ce type de gravure est aussi qualifié de « nettoyage humide » traduction de l'anglais « wet clean ».

La **figure 1b** illustre un premier problème qui est en relation avec la sélectivité insuffisante d'attaque qui existe lors d'une gravure sèche de type CH3F/O2/He entre le nitrure de silicium et le silicium de la couche superficielle 146. Le résultat est qu'une fraction significative de la mince couche superficielle de silicium monocristallin 146 du substrat SOI peut être alors partiellement consommée 147 lors de la gravure anisotrope du nitrure. Comme précédemment mentionné, la couche superficielle 146 est choisie pour être de faible épaisseur afin d'améliorer les caractéristiques électriques des transistors. Elle est typiquement inférieure à 10 nm. L'épaisseur restante 145 peut être très faible. Dans ces conditions l'implantation ionique 105 pour former les zones de source et de drain 110 qui va suivre est susceptible d'être très dommageable pour le silicium monocristallin restant. L'énergie d'implantation des dopants peut être suffisante pour provoquer une amorphisation complète 149 du silicium monocristallin ce qui va alors notamment compromettre l'étape de croissance épitaxiale 112 suivante destinée à former les source/drain surélevés. Une croissance à partir d'une couche de silicium partiellement ou totalement rendue amorphe va créer de nombreux défauts dans la couche formée par épitaxie.

La **figure 1c** illustre un autre problème où il n'y a pas consommation significative du silicium de la couche superficielle 146 mais il y a formation de « pieds » 154 au bas des motifs de nitrure de silicium restants sur les flancs de la grille après gravure. La conséquence est que la transition 114 des jonctions qui sont formées après dopage par implantation ionique 105 des zones de source et drain 110, avec la zone du canal 130, est beaucoup moins abrupte que lorsque les espaceurs n'ont pas de pieds comme représenté dans les figures précédentes. La présence de pieds 154 affecte les caractéristiques électriques des transistors. On remarquera ici que la formation ou non de pieds au bas des espaceurs et la consommation ou non de silicium de la couche superficielle de silicium 146 du substrat SOI, décrite dans la figure précédente, sont des paramètres de réglage antagonistes de la gravure qui nécessitent qu'un compromis puisse être trouvé pour lequel, idéalement, on ne forme pas de pieds et on n'attaque pas significativement la couche superficielle de silicium.

La **figure 1d** illustre un troisième problème qui se produit quand la gravure produit une érosion trop importante des espaceurs dans les parties hautes des grilles et met à nu le silicium polycristallin 123 dans ces zones 156. La conséquence est que la croissance épitaxiale 112 ultérieure pour former les source/drain surélevés va aussi se produire à ces endroits, ainsi qu'une siliciuration de contacts parasites, ce qui risque de provoquer des courts circuits entre électrodes. En effet, la gravure des espaceurs demande que le temps de gravure soit ajusté pour graver, par exemple, 150% de l'épaisseur de nitrure déposé. C'est-à-dire que l'on pratique une surgravure de 50% dans cet exemple afin de tenir compte de la non-uniformité du dépôt, ou de l'opération de gravure elle-même, au niveau d'une tranche. Ainsi, dans certaines parties de la tranche on pourra constater qu'il y a une surgravure trop prononcée qui met à nu les zones de grille 156. Ce type de défaut est aussi qualifié de « facettage ».

D'autres solutions ont été proposées dans les documents US2014/0273292 et, FR12/62962. Ces solutions prévoient une étape de modification par implantation d'une couche de nitrure de silicium pour la modifier de part et d'autre de la grille, suivie d'une étape de retrait de la couche de nitrure de silicium modifiée.

Dans la solution FR12/62962 l'étape de retrait de la couche de nitrure modifiée peut être réalisée par un nettoyage humide à base d'acide fluorhydrique (HF). L'inconvénient est que le nettoyage humide à base de HF ne permet pas un retrait sélectif de la couche de nitrure modifiée vis-à-vis de la couche de nitrure non-modifiée. La sélectivité à la couche de nitrure non modifié est, par exemple, de 7 (pour une concentration de HF de 1%).

Par ailleurs l'acide fluorhydrique est un composé chimique dont l'une des principales propriétés est de graver l'oxyde de silicium, donc cette méthode est intrinsèquement non-sélective à la couche d'oxyde de silicium formant le masque dur ainsi que les tranchées d'isolation (en anglais acronyme STI pour « shallow trench isolation »). La sélectivité de cette couche d'oxyde au HF est, par exemple, de 1 (pour une concentration de HF de 1%).

La présente invention a pour objet de proposer un procédé de formation d'espaceurs qui supprimerait ou limiterait au moins certains des défauts dans la réalisation de transistors, tels que la consommation ou l'altération du matériau semi-conducteur (i.e. Si, SiGe) de la couche active sous-jacente à la couche à graver, la formation de « pieds » au bas des motifs sur les flancs de la grille d'un transistor, la consommation d'un masque dur ou d'une tranchée d'isolation à base d'oxyde.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de formation d'espaceurs d'une grille d'un transistor à effet de champ, la grille comprenant des flancs et un sommet et étant située au-dessus d'une couche en un matériau semi-conducteur, le procédé comprenant une étape de formation d'une couche diélectrique recouvrant la grille du transistor, le procédé comprenant :
- après l'étape de formation de la couche diélectrique, au moins une étape de modification de ladite couche diélectrique par implantation d'ions au moins dans des portions de la couche diélectrique qui sont situées sur un sommet de la grille et de part et d'autre de la grille et qui sont perpendiculaires aux flancs de la grille en conservant des portions de la couche diélectrique recouvrant les flancs de la grille non-modifiées ou non-modifiées sur toute leur épaisseur; les ions étant des ions à base d'hydrogène (H) et/ou à base d'hélium (He);
- au moins une étape de retrait de la couche diélectrique modifiée à l'aide d'une gravure sélective de ladite couche diélectrique modifiée vis-à-vis de la couche en un matériau semi-conducteur et vis-à-vis de la couche diélectrique non modifiée.

La couche diélectrique est en un matériau pris parmi : un nitrure de silicium (SixNy tel que le SiN), SiC, SiCN, SiCBN et l'étape de retrait de la couche diélectrique modifiée comprend une gravure humide à base d'une solution comprenant de l'acide fluorhydrique (HF) diluée à x% en masse, avec x≤0.2 et présentant un pH inférieur ou égal à 1.5.

Il s'est avéré qu'avec ces conditions de retrait, en particulier l'association entre cette acidité spécifique de la solution et cette dilution spécifique du HF, on grave la couche diélectrique modifiée de manière particulièrement sélective vis-à-vis de la couche en un matériau semi-conducteur et vis-à-vis de la couche diélectrique non modifiée. Ainsi, on évite ou tout au moins on réduit la consommation ou l'altération du matériau semi-conducteur (i.e. Si, SiGe) de la couche active sous-jacente à la couche à graver et la formation de « pieds » au bas des motifs sur les flancs de la grille d'un transistor.

Par ailleurs, de manière particulièrement surprenante cette gravure permet d'augmenter de manière très significative la sélectivité de la gravure de la couche diélectrique modifiée vis-à-vis des matériaux à base d'oxyde de silicium, désigné de manière générale SiOy dans la présente demande de brevet, avec y entier supérieur ou égal à 1.

Cette sélectivité améliorée est très avantageuse puisque bien souvent un masque dur sur le sommet de la grille ou une tranchée d'isolation, à base de SiOy, sont présents lors de l'étape de gravure.

Il s'ensuit que le masque dur ou les tranchées d'isolation ne sont pas altérées par la gravure des espaceurs. Ils peuvent donc pleinement jouer leurs rôles.

Habituellement des pH aussi acides ne sont pas utilisés car ils ne présentent pas d'intérêt dans le cadre de gravure classique de SiOy tel que le SiO2.

La démarche habituelle de l'homme de métier l'aurait conduit à augmenter le pH dans le but d'améliorer la sélectivité et pour une concentration donnée de HF. En tout état de cause l'homme du métier n'aurait trouvé aucune incitation à : à la fois baisser le pH jusqu'à une valeur inférieure ou égale à 1.5 et à diluer le HF jusqu'à une dilution inférieure ou égale à 0.2. Il n'aurait pas pu prévoir ce résultat surprenant procuré par l'invention.

Or, cet avantage surprenant procuré par l'invention réside bien dans cette combinaison spécifique de ce pH et de cette dilution.

Par exemple, avec le procédé selon l'invention, on obtient une sélectivité de la gravure par rapport au dioxyde de silicium telle que pour une épaisseur e1 de nitrure modifié gravée, on ne grave dans le même temps qu'une épaisseur e1/33.7 de dioxyde de silicium.

Ainsi, l'invention permet d'obtenir des espaceurs à base d'un matériau diélectrique tout en réduisant voire en éliminant certains au moins des problèmes des solutions connues et mentionnés précédemment.

De manière facultative, le procédé peut en outre présenter au moins l'une quelconque des caractéristiques et étapes ci-dessous.
- La solution utilisée lors de l'étape de retrait est obtenue par mélange d'une solution de HF diluée et d'un composant permettant de réduire le pH de la solution de HF. Ce composant est par exemple du HCl. Alternativement il peut être du H₂SO₄ (acide sulfurique), HNO₃ (acide nitrique). Cette liste n'est pas exhaustive, tout acide ne générant pas d'espèces susceptibles de graver un des matériaux considérés pourrait convenir dans le cadre de l'invention.
- La solution peut être obtenue par mélange uniquement d'une solution de HF diluée dans de l'eau H2O et de HCl. Alternativement elle peut également contenir du H₂SO₄, ou HNO₃.
- La solution pourrait aussi être préparée à partir de HF concentré dilué dans de l'eau H2O additionnée de HCl ou H2SO4 ou HNO3.
- Selon un mode de réalisation, le pH est inférieur ou égal à 1.3, de préférence inférieur ou égal à 1. Selon un mode de réalisation, le pH est strictement inférieur à 1.
- Selon un mode de réalisation, le pourcentage de HF est compris entre 0.02% et 0.2% en masse. Selon un mode de réalisation, le pourcentage de HCl est compris entre 0.3% à 3% en masse.
- Selon un mode de réalisation, x≤0.15, de préférence x≤0.1. Selon un mode de réalisation est sensiblement égal à 0.1. Selon un mode de réalisation x <0.1.
- Selon un mode de réalisation, la gravure sélective de ladite couche diélectrique modifiée vis-à-vis de la couche diélectrique non modifiée présente une sélectivité supérieure ou à égale à 11.
- Selon un mode de réalisation, le procédé comprend, avant l'étape de retrait une étape de formation d'un masque (124) situé sur le sommet de la grille, ledit masque étant à base d'oxyde de silicium SiOy y étant un entier supérieur ou égal à 1, et de préférence à base de dioxyde de silicium (SiO2).
- Selon un mode de réalisation, le procédé comprend, avant l'étape de retrait une étape de formation d'une tranchée d'isolation s'étendant à travers la couche en un matériau semi-conducteur, ladite tranchée d'isolation étant à base d'oxyde de silicium SiOy, y étant un entier supérieur ou égal à 1, et de préférence à base de dioxyde de silicium (SiO2).
- Selon un mode de réalisation, la gravure sélective de ladite couche diélectrique modifiée vis-à-vis de l'oxyde de silicium SiOy présente une sélectivité supérieure ou égale à 33.
- Selon un mode de réalisation, la couche diélectrique est formée d'un ou plusieurs matériaux diélectriques dont la constante diélectrique k est inférieure ou égale à 7.
- Selon un mode de réalisation, le procédé comprend une unique étape de modification effectuée de sorte à modifier la couche diélectrique dans toute son épaisseur sur toutes les surfaces parallèles au plan d'un substrat sur lequel repose la grille et à ne pas modifier la couche diélectrique dans toute son épaisseur sur les surfaces perpendiculaires à ce plan.
- Selon un mode de réalisation, la couche en un matériau semi-conducteur est pris parmi: le silicium (Si), le germanium (Ge), le silicium-germanium (SiGe).
- Selon un mode de réalisation, l'étape de modification de ladite couche diélectrique par implantation d'ions comprend la mise en présence de la couche diélectrique avec un plasma créant une implantation anisotrope d'ions selon une direction privilégiée parallèle à des flancs de la grille.
- Selon un mode de réalisation, les conditions du plasma, en particulier l'énergie des ions et la dose implantée sont choisies de manière à modifier, par implantation des ions, au moins des portions de la couche diélectrique qui sont situées sur un sommet de la grille et de part et d'autre de la grille et qui sont perpendiculaires aux flancs de la grille en conservant des portions de la couche diélectrique recouvrant les flancs de la grille non-modifiées ou non-modifiées sur toute leur épaisseur.

Alternativement, l'étape de modification de ladite couche diélectrique par implantation d'ions comprend une implantation anisotrope d'ions selon une direction privilégiée parallèle à des flancs de la grille, l'implantation étant réalisée par un implanteur.
- Selon un mode de réalisation, les ions sont des ions à base d'hydrogène (H) et/ou à base d'hélium (He). Selon un mode de réalisation, le plasma est obtenu par injection dans un réacteur de gaz notamment pris parmi l'hélium (He) et/ou l'hydrogène (H2) et/ou l'ammoniac (NH3). Selon un mode de réalisation, le plasma est obtenu par injection dans un réacteur de gaz notamment pris parmi l'hélium (He), l'hydrogène (H2) et l'ammoniac (NH3) le débit d'injection de ces gaz étant respectivement de 50 à 500 sccm, 10 à 500sccm, 10 à 500 sccm.
- Selon un mode de réalisation, les ions sont à base d'hydrogène et sont pris parmi : H, H+, H2+, H3+.
- Selon un mode de réalisation, l'étape de modification de la couche diélectrique est réalisée avec une puissance de polarisation ou puissance de source comprise entre 20V (volt) et 500V, avec une pression comprise entre 5 mTorr (milliTorr) et 100 mTorr, à une température comprise entre 10°C et 100°C, pendant une durée de quelques secondes à quelques centaines de secondes.
- Selon un mode de réalisation, l'étape de modification de la couche diélectrique réalisée à partir d'un plasma modifie la couche diélectrique de manière continue depuis la surface de la couche diélectrique et sur une épaisseur comprise entre 1 nm (nanomètre) et 30 nm, de préférence comprise entre 1 nm et 10 nm.
- Selon un mode de réalisation, la couche isolante est disposée au contact de la couche en un matériau semi-conducteur, formant le canal de conduction. De préférence, la couche est disposée au contact de la couche. De préférence, la couche est disposée directement au contact de l'oxyde de grille formée par la couche, si la couche est absente ou est disposée directement au contact de la couche. De préférence, la couche diélectrique est disposée directement au contact de la couche au niveau des flancs de la grille. De préférence, la couche diélectrique est disposée directement au contact de la couche en un matériau semi-conducteur destinée à former le canal de conduction.
- Selon un mode de réalisation, le transistor est un transistor de type FDSOI ou de type FinFET.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURE 1a à 1d montrent, d'une part, une vue en coupe d'un exemple de transistor MOSFET de type FDSOI en cours de réalisation et, d'autre part, illustrent différents défauts qui peuvent être observés sur des structures de transistors FDSOI lors de la gravure des espaceurs en utilisant l'un ou l'autre des procédés standard de gravure anisotrope développés par l'industrie de la microélectronique.
Les FIGURES 2a à 2d illustrent les étapes d'un exemple de procédé selon l'invention appliqué à la réalisation de transistors.
La FIGURE 3 illustre un graphe représentant la concentration en espèce fluorées dans la solution en fonction du pH de la solution.
La FIGURE 4 résume les étapes d'un exemple de procédé de l'invention destinées à former des espaceurs et qui n'induisent pas ou tout au moins limitent les défauts décrits dans les figures 1b à 1d.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte » ou « sous-jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Dans la description qui suit, une solution de HF diluée à x% correspond à une concentration massique. Une solution de HF diluée à x% signifie que la masse de HF représente x% de la masse totale de la solution. On notera, comme cela sera détaillé par la suite que l'ajout de l'acide de préférence fort tel que le HCl dans la solution initiale (c'est-à-dire après dilution du HF mais avant ajout de l'acide), ne modifie pas significativement ou ne modifie que très peu le % massique de HF. Ainsi, le % massique de HF varie très peu entre la solution initiale et la solution finale (c'est-à-dire après ajout de l'acide).

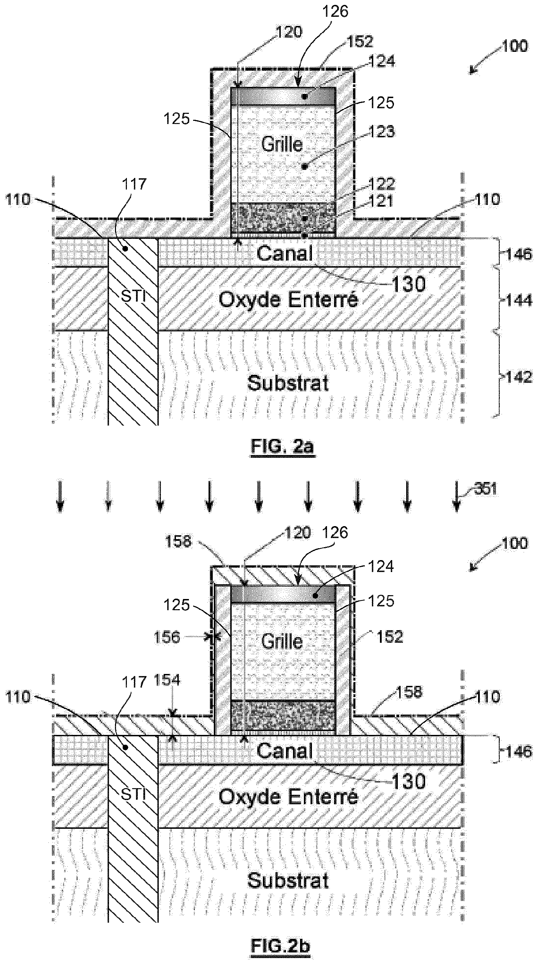

Les **figures 2a à 2d** décrivent les étapes d'un exemple détaillé d'un procédé selon l'invention appliqué à la réalisation de transistors par exemple de type FDSOI sans que ce type de transistor soit limitatif.

Dans les transistors de type FDSOI, la couche superficielle de silicium monocristallin 146 peut être contrôlée précisément en épaisseur et en dopage. En particulier, il est avantageux pour les performances des transistors que le canal 130 soit complètement déserté de porteurs, c'est-à-dire « fully depleted » (FD), vocable anglais qui est généralement utilisé pour désigner cet état. Ceci peut être obtenu en réalisant les transistors à partir de substrats SOI dont la couche superficielle 146 est très mince.

Les principes des étapes suivantes peuvent également s'appliquer à la formation d'espaceurs sur les flancs 125 d'une grille 120 d'un autre type de transistor.

La **figure 2a** illustre l'étape de dépôt d'une couche diélectrique 152, d'épaisseur préférentiellement sensiblement uniforme, sur toutes les surfaces, verticales et horizontales, des dispositifs en cours de fabrication. Cette étape, se fait de préférence à l'aide d'une méthode de dépôt dite LPCVD, acronyme de l'anglais « low pressure chemical vapor déposition », c'est-à-dire « dépôt chimique en phase vapeur à faible pression ». Ce type de dépôt qui se pratique à pression sous atmosphérique permet en effet un dépôt uniforme sur toutes les surfaces quelle que soit leur orientation.

Quoi que cela ne soit pas nécessaire à la compréhension du procédé de l'invention, on notera que l'électrode de grille est dans cet exemple composée, à ce stade, du procédé de plusieurs couches pour certains types de transistors. Outre la couche de silicium polycristallin ou monoctristallin 123, on retrouve, dans l'empilement des couches formant la grille 120, tout d'abord la mince couche isolante d'oxyde de grille 121 à travers laquelle un champ électrique va pouvoir se développer pour créer le canal 130 de conduction sous-jacent entre source et drain, quand une tension électrique suffisante est appliquée sur la grille. Dans les transistors MOSFET les plus récents, il est mis en oeuvre une technologie qualifiée du vocable anglais de « high-k/metal gate » c'est-à-dire que la couche isolante 121 est faite d'un matériau isolant à haute permittivité (high-k) couverte par une grille métallique (metal gate) représentée par la couche 122. Cette technologie a été développée notamment pour réduire les courants de fuite à travers la grille qui devenaient beaucoup trop importants en raison de la diminution de l'épaisseur de la couche isolante 121 jusqu'à des dimensions atomiques. À ce stade, l'empilement de couches de la grille comprend aussi un masque dur 124 de protection qui sera enlevé ultérieurement pour permettre la reprise de contact sur cette électrode. Ce masque dur, qui reste en place après gravure de la grille, est typiquement fait d'oxyde de silicium (SiOy) y étant un entier supérieur ou égal à 1 et le plus souvent en dioxyde de silicium SiO2. Son rôle est de protéger le sommet 126 de la grille de tout dommage lors de la gravure des espaceurs.

On prévoit également la formation de tranchées d'isolation 117 dont la fonction est d'isoler électriquement des régions de la couche active 146 en un matériau semi-conducteur. Une tranchée d'isolation 117 est formée d'un matériau diélectrique qui traverse la couche active 146 pour s'étendre jusque dans la couche isolante par exemple faite d'un oxyde enterrée 144. Souvent la tranchée d'isolation s'étend de manière à traverser toute la couche isolante 144 jusqu'à atteindre le substrat de support 142. Les tranchées d'isolation 117 pour ce type de transistors sont souvent qualifiées de STI, acronyme du vocable anglais « shallow trench isolation ».

Selon un mode de réalisation, la couche diélectrique 152 est à base de nitrure. Selon un mode de réalisation, la couche diélectrique 152 de nitrure a une épaisseur comprise entre 5 et 20 nm, et typiquement de l'ordre de 10 nm. A titre d'exemple, la couche diélectrique 152 est à base de nitrure de silicium (SiN). La couche diélectrique 152 peut également être choisie parmi le carbure de silicium (SiC), le carbonitrure de silicium (SiCN), le carbonitrure de bore et de silicium (SiCBN).

Selon un autre mode de réalisation, la couche diélectrique 152 comprend un matériau diélectrique à faible permittivité ε (la permittivité est notée epsilon) ou à faible constante diélectrique k, avec de préférence k inférieur ou égal à 7. Ainsi, la présente invention n'est pas limitée à une couche diélectrique formée à base de nitrure. La présente invention n'est, par ailleurs, pas non plus limitée à une couche diélectrique de nitrure de silicium (SiN).

La présente invention s'étend avantageusement à tout espaceur comprenant un matériau diélectrique à faible permittivité ε (dit « low-k » en anglais). On entend par « permittivité d'un matériau », au niveau microscopique, la polarisabilité électrique des molécules ou atomes constituant ledit matériau. La permittivité d'un matériau est une grandeur tensorielle (la réponse du matériau peut dépendre de l'orientation des axes cristallographiques du matériau), qui se réduit à un scalaire dans les milieux isotropes. La constante diélectrique est notée k dans le domaine des circuits intégrés et des semi-conducteurs, par exemple. Les matériaux dits « low-k » sont des diélectriques à faible permittivité. Ils sont utilisés comme isolants entre les interconnexions métalliques pour diminuer le couplage entre celles-ci.

Dans un mode de réalisation, la couche diélectrique 152 présente ou comprend un matériau présentant une constante diélectrique inférieure à 7, de préférence à 4 et de préférence inférieure à 3.1 et de préférence inférieure ou égale à 2, ce qui permet ainsi de réduire la capacité parasite pour éventuellement améliorer la performance du transistor. Par exemple, comme indiqué ci-dessus le matériau de la couche diélectrique 152 est pris parmi : le SiC, le SiCN, le SiCBN. Cela permet de réduire la capacité parasite et d'améliorer en conséquence la performance du transistor.

De manière préférentielle mais uniquement facultative, le procédé de l'invention comprend une étape facultative de réduction de la constante diélectrique de la couche diélectrique 152. Selon un mode de réalisation avantageux, la réduction de la constante diélectrique est obtenue lors de l'étape de dépôt de la couche diélectrique 152.

Selon un mode de réalisation, la réduction de la constante diélectrique comprend l'introduction dans la couche diélectrique 152 en formation de précurseurs qui forment des liaisons réduisant la polarisabilité de la couche diélectrique 152. Ces précurseurs sont choisis de manière à générer des liaisons moins polaires que le nitrure de silicium, telles que le Si-F, le SiOF, le Si-O, le C-C, le C-H, et le Si-CH3.

Selon un autre mode de réalisation, alternatif ou combinable au précédent, la réduction de la constante diélectrique comprend l'introduction dans la couche diélectrique 152 en formation d'une porosité.

La **figure 2b** illustre l'étape suivante de l'invention dans laquelle on procède directement à une modification 430 de la couche diélectrique 152 que l'on vient de déposer. Optionnellement, cette opération pourra avoir été précédée d'une gravure 420 « principale », par exemple une gravure sèche conventionnelle de type CH3F/O2/He.

L'étape de modification 430 de la couche diélectrique 152 telle que déposée, ou de la couche restante après une première gravure conventionnelle, se fait par implantation 351 d'espèces légères également désignées ions légers. Dans le cadre de la présente invention, ces ions sont des ions à base d'hydrogène (H) et/ou à base d'hélium (He).

Les ions à base d'hydrogène (H) sont par exemple pris parmi : H, H+, H2+, H3+.

Avantageusement, ces espèces peuvent être prises seules ou en combinaison. Par exemple, les chimies possibles pour l'implantation sont : H, He, NH3, He/H2, He/NH3. Ces ions peuvent être implantés dans un matériau à graver, sans provoquer de dislocation de sa structure atomique telle qu'elle entraînerait une pulvérisation de ce dernier.

On entend par « ions légers » des ions provenant de matériaux dont le numéro atomique dans la classification périodique des éléments est faible. D'une façon générale tous les éléments que l'on peut implanter dans le matériau à graver, sans provoquer de dislocation de sa structure atomique telle qu'elle entraînerait une pulvérisation de ce dernier, et donc sans re-dépôt du matériau gravé sur les parois du réacteur ou les motifs en cours de gravure eux-mêmes, sont susceptibles de convenir.

De manière particulièrement avantageuse, l'implantation d'espèces légères est favorisée par l'incorporation dans le plasma d'un composant permettant la dissociation des ions légers et donc l'augmentation de la densité d'ions légers dans le plasma et l'augmentation de la dose implantée.

Avantageusement, les paramètres d'implantation, en particulier l'énergie communiquée aux ions, la durée et la dose d'implantation sont prévus de sorte que la couche diélectrique modifiée 158 puisse être gravée sélectivement par rapport à la couche 146 en un matériau semi-conducteur.

Avantageusement, ces paramètres sont également réglés de manière à ce que la couche diélectrique modifiée 158 puisse être gravée sélectivement par rapport à la portion non modifiée de la couche diélectrique 152.

Avantageusement, ces paramètres sont également réglés de manière à ce que la couche diélectrique modifiée 158 puisse être gravée sélectivement par rapport à une couche faite d'un oxyde typiquement un oxyde dudit matériau semi-conducteur, cette dernière formant par exemple une couche d'oxyde de grille, un masque dur 124 ou une tranchée d'isolation 117. Typiquement, la gravure est sélective du matériau diélectrique modifié par implantation d'hydrogène vis-à-vis de l'oxyde de silicium SiOy.

L'implantation s'effectue, selon un exemple non limitatif de l'invention, dans un plasma à base d'hydrogène gazeux (H2). De manière plus générale, tous les composants gazeux, pouvant par dissociation libérer les ions légers cités précédemment, peuvent être utilisés dans le plasma. On notera ici que cette étape de modification 430 de la couche diélectrique 152 à graver peut se pratiquer de nombreuses façons différentes en adaptant toutes sortes de moyens couramment employés par l'industrie de la microélectronique. On utilise notamment des réacteurs de gravure standard dans lesquels on peut réaliser des plasmas à faible ou haute densité et où on peut contrôler l'énergie des ions pour permettre l'implantation des espèces légères ci-dessus destinées à modifier la couche à graver. On peut aussi utiliser un type de plasma dit par immersion couramment utilisé pour pratiquer une implantation d'espèces en surface d'un dispositif en cours de fabrication.

Enfin, l'implantation peut aussi se faire dans un implanteur standard où l'on accélère les ions dans un champ électrique pour obtenir leur implantation dans un solide.

L'opération de modification est avantageusement très anisotrope pour la réalisation des espaceurs sur les flancs 125 des grilles en raison de la directionnalité des ions du plasma ou de l'implanteur. Elle affecte donc préférentiellement les surfaces horizontales, c'est-à-dire toutes les surfaces parallèles au plan du substrat 142. L'épaisseur modifiée sur les surfaces horizontales 154 est ainsi nettement plus importante que sur les surfaces verticales 156 c'est-à-dire sur toutes les surfaces perpendiculaires au plan du substrat 146 élaboré, sur lequel est disposée la grille. Avantageusement, l'implantation selon la présente invention permet de ne pas attaquer les surfaces verticales. Ainsi, selon un mode de réalisation préféré, l'épaisseur modifiée sur les surfaces verticales 156 est quasi-nulle, de préférence de l'ordre de 1 à 3 nanomètres.

Ce plan est perpendiculaire au plan de la coupe représentée sur les figures 2a à 2d. Le substrat 142 élaboré forme de préférence une plaque (ou «wafer» en anglais) avec deux faces parallèles. Il se présente par exemple sous la forme d'un disque, d'un carré, d'un polygone, etc. La couche mince 146, la couche d'oxyde enterrée 144 et le substrat massif 142 sont disposés selon des plans parallèles. Ainsi, une surface sera qualifiée d'horizontale si elle est parallèle au plan de la couche ou des couches formant le substrat 146, sur lequel est formée la grille et une surface sera qualifiée de verticale si elle est perpendiculaire à ce même plan.

Typiquement, une épaisseur 154 de 10 nm sur les surfaces horizontales peut être modifiée au cours de cette opération. Une épaisseur 156 de la couche 152 allant de 1 à 3 nm est toutefois également modifiée sur les surfaces verticales quelles que soient les conditions du plasma. Ces surfaces verticales par rapport au plan du substrat 146 sont donc parallèles aux flancs 125 de la grille. Les épaisseurs modifiées dépendent des conditions de mise en oeuvre, notamment des moyens employés (plasma ou implanteur) et aussi du fait que l'on désire obtenir la gravure des espaceurs en une seule étape globale de modification et de gravure ou qu'au contraire on répète ces opérations jusqu'à obtenir une gravure complète.

Ainsi, en fonction des mises en oeuvre particulières du procédé de l'invention et de l'épaisseur initiale de la couche diélectrique 152, l'étape de modification de cette couche peut affecter la totalité de cette couche où, comme représenté dans l'exemple de la figure 2b, une partie seulement de celle-ci. Dans ce cas particulier, le matériau est modifié sur toute son épaisseur mais uniquement au niveau des zones horizontales 154. Dans ce cas, l'étape de modification 430 et l'étape suivante de retrait 440 de la couche modifiée décrite ci-après pourront être répétées jusqu'à enlèvement complet du matériau diélectrique de la couche diélectrique modifiée 158 sur toutes les surfaces horizontales.

L'implantation par plasma a pour avantage de permettre une implantation de manière continue dans un volume s'étendant dès la surface de la couche implantée. En outre, l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur d'une couche diélectrique 152, typiquement comprise entre 1 et 10 nm et plus généralement entre 1 et 30 nm.

L'étape de modification réalisée à partir d'un plasma modifie la couche diélectrique 152 de manière continue depuis la surface de la couche diélectrique 152 et sur une épaisseur comprise entre 1 nm et 30 nm et de préférence entre 1 nm et 10 nm.

De préférence, la modification de la couche diélectrique 158 conserve une épaisseur de diélectrique non modifié 152 sur les flancs 125 de la grille. Cette épaisseur est conservée, au moins en partie, lors de la gravure sélective. Elle définit alors des espaceurs 150 de grille.

De préférence, les paramètres de l'implantation, notamment l'énergie d'implantation des ions légers et la dose implantée, sont prévues de sorte que la couche diélectrique modifiée 158 puisse être gravée de manière sélective vis-à-vis du matériau de la couche 146 en un matériau semi-conducteur et vis-à-vis de la couche diélectrique non modifiée 152.

De préférence, une unique étape de modification est effectuée de sorte à modifier la couche diélectrique 152 dans toute son épaisseur sur toutes les surfaces parallèles au plan d'un substrat sur lequel repose la grille et à ne pas modifier la couche diélectrique 152 dans toute son épaisseur sur les surfaces parallèles à la direction privilégiée d'implantation.

De préférence, l'implantation modifie la couche diélectrique 152 de manière ininterrompue depuis la surface.

Selon un mode de réalisation particulier, le procédé comprend une unique étape de modification 430 effectuée de sorte à modifier la couche diélectrique 152 dans toute son épaisseur sur toutes les surfaces parallèles au plan d'un substrat sur lequel repose la grille et à ne pas modifier la couche diélectrique 152 dans toute son épaisseur sur les surfaces perpendiculaires à ce plan. Ces surfaces perpendiculaires à ce plan, c'est-à-dire perpendiculaire à la couche 146 en un matériau semi-conducteur formant un canal de conduction ou au substrat massif sont typiquement parallèles aux flancs 125 de la grille du transistor. Ainsi, suite à cette unique étape de modification 430, un retrait 440 qui sera décrit par la suite sélectif de la couche diélectrique modifiée 158 permet de retirer la couche diélectrique sur toutes les surfaces exceptées sur celles parallèles aux flancs 125 de la grille.

Selon un autre mode de réalisation, le procédé comprend plusieurs séquences comprenant chacune une étape de modification 430 et une étape de retrait 440. Au cours d'au moins l'une des étapes de modification 430, seule une partie de l'épaisseur de la couche diélectrique 152 est modifiée. Ce mode de réalisation a pour avantage de retirer des épaisseurs plus importantes de matériau. Il est ainsi préférable d'effectuer plusieurs cycles comprenant chacun une modification puis un retrait. Avantageusement, les séquences sont répétées jusqu'à disparition de la couche diélectrique 152 sur toutes les surfaces parallèles au plan d'un substrat sur lequel repose la grille. Seules les faces parallèles aux flancs 125 de la grille conservent une épaisseur de diélectrique, cette épaisseur n'ayant pas fait l'objet de modification par implantation.

Selon un mode de réalisation avantageux, la couche diélectrique 152 est disposée directement au contact de la couche 146 en un matériau semi-conducteur. De préférence la couche diélectrique 152 est disposée directement au contact de la grille qui est de préférence formée dans un matériau semi-conducteur.

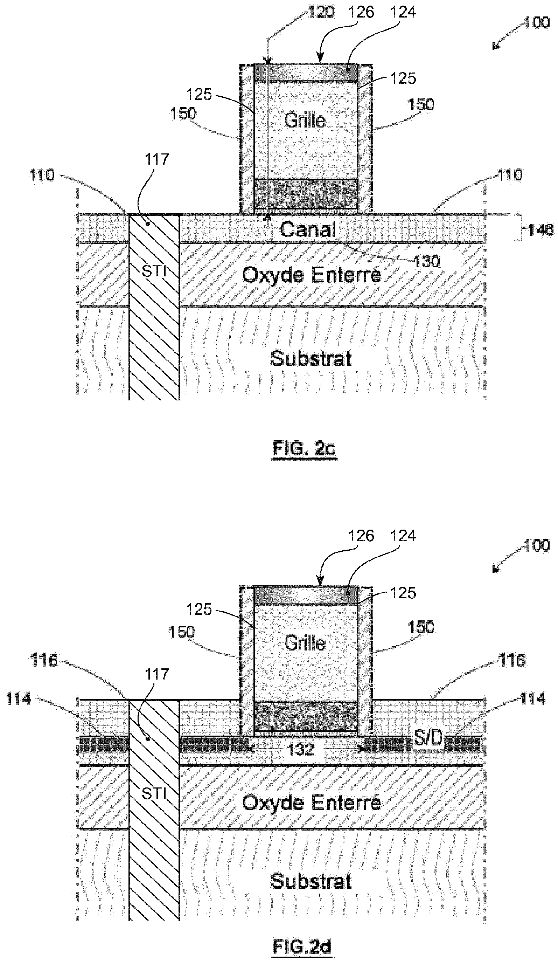

La **figure 2c** illustre le résultat final de l'étape suivante après avoir procédé à la gravure, c'est-à-dire au retrait sélectif 440 de la couche diélectrique modifiée 158.

Ce retrait sélectif comprend une gravure effectuée par mise en présence de l'empilement, en particulier de la couche diélectrique 152 avec une solution comprenant de l'acide fluorhydrique (HF). Plus particulièrement cette solution est obtenue à partir d'une solution de HF diluée à x%, avec x<0.2.

Avantageusement elle présente un pH inférieur à 1.5.

La diminution du pH pour augmenter l'acidité est par exemple obtenue par ajout d'acide chlorhydrique à la solution de HF diluée à x%.

Comme indiqué ci-dessus, la concentration de HF à x% correspond à la concentration massique de HF dans la solution initiale c'est-à-dire avant ajout de HCl. Cependant, le volume nécessaire de HCl pour abaisser le pH de la solution à la valeur désirée est très faible.

A titre d'exemple non limitatif, 24ml (10⁻³ litres) de HCl concentré à 36% en masse suffisent à abaisser le pH en-dessous de 1 pour une solution de 3 litres de HF diluée à 0.1% en masse. En conséquence la concentration du HF passe de 0.1% à 0.0997% en masse dans la solution finale après ajout de HCl. La concentration en HCl dans un tel mélange est de 0.3% en masse.

Selon un mode de réalisation, dans la solution finale, les concentrations en HF et en HCl sont les suivantes : HF 0.098% et HCl 0.7%.

Les gammes utilisables sont de préférence : HF de 0.02% à 0.2% en masse, HCl de 0.3% à 3% en masse.

Cette solution spécifique à base d'HF permet de graver la couche diélectrique modifiée 158 de manière sélective vis-à-vis de la couche 146 en un matériau semi-conducteur et vis-à-vis de la couche diélectrique non modifiée 152.

De manière particulièrement avantageuse, et contrairement aux solutions d'HF diluée à 1% et dont le pH est proche de 2.5, la solution d'HF selon l'invention permet de graver la couche diélectrique modifiée 158 de manière très sélective vis-à-vis des couches d'oxyde. Ainsi le masque dur 124 ou les tranchées d'isolation 117 faits en oxyde, par exemple en dioxyde de silicium SiO2 ne sont pas altérés par la gravure.

Le tableau suivant donne un exemple des épaisseurs (en nanomètres 10⁻⁹ mètres) consommées au bout d'une durée de 600 secondes par une solution de HF diluée à 0.1% et présentant un pH de 0.93 :

| pH du Bain | nature de la couche | Consommation (nm) |
|---|---|---|
| 0,93 | oxyde | 0,3 |
| | SiN | 0,9 |
| | SiN modifié par implantation | 10,1 |

A titre de comparaison, le tableau suivant donne un exemple des épaisseurs consommées au bout d'une durée de 600 secondes par une solution de HF diluée à 0.1% et présentant un pH de 2.43:

| pH du bain | nature de la couche | Consommation (nm) |
|---|---|---|
| 2.43 | oxyde | 2.8 |
| | SiN | 1.1 |
| | SiN modifié par implantation | 11.5 |

Ainsi, la sélectivité (rapport des vitesses de gravure) de la gravure du SiN modifié par rapport au SiN non modifié est de 11.2.

De manière encore plus marquée, la sélectivité de la gravure du SiN modifié par rapport au SiO2 est de 33.7. Cela permet de contrôler de manière très précise la gravure des portions modifiées 158 de la couche diélectrique 152 par rapport aux couches en oxyde de silicium telles que les tranchées d'isolation 117, le masque dur 124 et l'oxyde de grille par exemple.

A titre de comparaison, les sélectivités de la gravure du SiN modifié par rapport au SiN non modifié et au SiO2 sont respectivement de 10.5 et 4.1 pour une solution de HF diluée à 0.1% et présentant un pH de 2.43:
La mise en présence est réalisée de préférence en plongeant l'empilement comprenant la couche diélectrique 152 dans un bain de la solution à base d'HF. De manière plus générale, le procédé pourrait être mis en oeuvre dans tout équipement permettant la mise en contact d'une solution liquide avec une plaque. Notamment on pourrait le faire par aspersion de liquide ou en immersion.

L'équipement utilisé pour cette étape de retrait peut par exemple être tout équipement de gravure ou nettoyage humide acceptant des pH faible et en particulier inférieur à 1.7 et de préférence inférieur à 1.

La gravure humide permet par exemple de retirer une épaisseur de la couche diélectrique modifiée 158 comprise entre 1 nanomètre et quelques dizaines de nanomètres.

L'arrêt de la gravure se fait au temps. Il se fait de préférence sur la couche diélectrique non modifiée 152 ou sur le silicium monocristallin de la couche 146 ou encore sur le masque dur 124 au sommet 126 des grilles 120 ou sur le sommet des tranchées d'isolation 117.

À l'issue de cette étape de retrait 440 il ne reste donc de la couche diélectrique 152 initiale que des motifs verticaux, essentiellement sur les flancs 125 de l'empilement de couches qui forment la grille 120. Ils constituent les espaceurs 150 de grille du transistor.

La **figure 2d** illustre l'étape 460 de formation des zones de drain et de source d'un transistor par exemple de type FDSOI.

A l'issue de la dernière ou unique étape de retrait de la couche diélectrique modifiée 158, c'est-à-dire lorsqu'on a fini de l'enlever sur toutes les surfaces horizontales, on procède à une opération de nettoyage dite « nettoyage humide » le plus souvent qualifiée par son vocable anglais de « wet clean ».

On peut ensuite procéder à la formation 470 des électrodes de source et de drain 110. Comme on l'a déjà mentionné, le dopage qui va délimiter source et drain et donc la longueur du canal 132 peut se faire par implantation ionique avant qu'on ne procède à une croissance épitaxiale sur ces zones afin d'augmenter leur section et diminuer leur résistance. Si le dopage est effectué avant croissance épitaxiale, comme représenté sur la figure 2d, le procédé est dit être « extension first » vocable anglais utilisé pour indiquer que les extensions (de source et de drain sous les espaceurs) sont réalisées en premier, c'est-à-dire avant croissance épitaxiale. Dans le cas contraire qui est dit être « extension last », on procède directement à l'étape de croissance épitaxiale sans dopage préalable. Le dopage des zones source/drain ne se fait qu'après croissance épitaxiale de ces zones. Dans le cas de transistors à canal de type n (nMOS), les dopants implantés sont typiquement l'arsenic (As) ou le phosphore (P). Pour les transistors à canal de type p (pMOS) les dopants sont le bore (B) ou le difluorure de bore (BF2).

Le résultat est illustré sur la figure 2d qui montre les zones source/drain dopées 114 avant croissance épitaxiale des zones source/drain surélevées 116.

Avantageusement, la grille du transistor est située sur un empilement de couches formant un substrat élaboré de type silicium sur isolant (SOI). De préférence, elle est disposée directement au contact de la couche formant le canal de conduction. Avantageusement, l'utilisation de l'invention avec un tel substrat SOI permet de préserver l'intégrité de la couche superficielle de très faible épaisseur qui forme le canal de conduction d'un transistor formé à partir d'un substrat SOI.

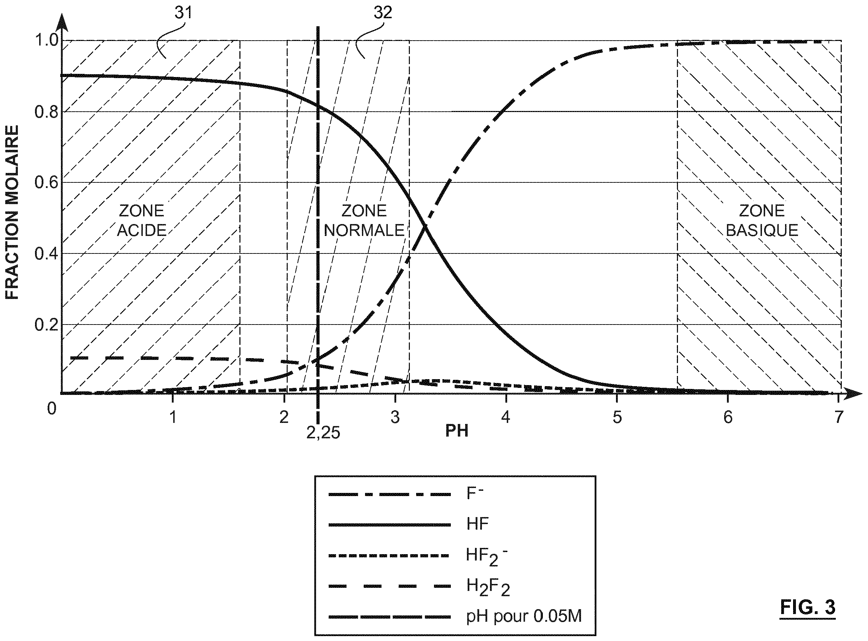

La **figure 3** illustre un graphe représentant la concentration, plus précisément la fraction molaire, des espèces fluorées dans la solution en fonction du pH de la solution.

On constate sur ce graphe que dans une zone 32 dont le pH est entre 2 et 4, les concentrations molaires en HF et en ions F⁻ sont importantes.
Lorsque l'on rajoute du HCl pour augmenter l'acidité de la solution et que le pH devient inférieur à 1.7, la concentration molaire en ions F⁻ est très fortement réduite et la concentration molaire en HF est très importante. Cela s'explique par l'association des ions H⁺ du HCl avec les ions F⁻ pour former des molécules de HF. Cela apparaît clairement dans la zone 31 du graphe.
Or, dans le cadre du développement de la présente invention il s'est avéré que ces ions F⁻ gravent le nitrure modifié avec une sélectivité moindre que les molécules de HF.

On notera que sur ce graphe, l'abréviation M est une abréviation du système international d'unités qui désigne une concentration en mol/L. La droite verticale notée pH pour 0.05M désigne le pH de la solution de HF de concentration 0.05M à l'équilibre, c'est-à-dire si l'on a uniquement le HF en solution dans l'eau sans chercher à modifier le pH. A noter que la concentration molaire de 0.05M correspond à la concentration massique 0.1%, le pH à l'équilibre d'une telle solution est égal à 2.25.

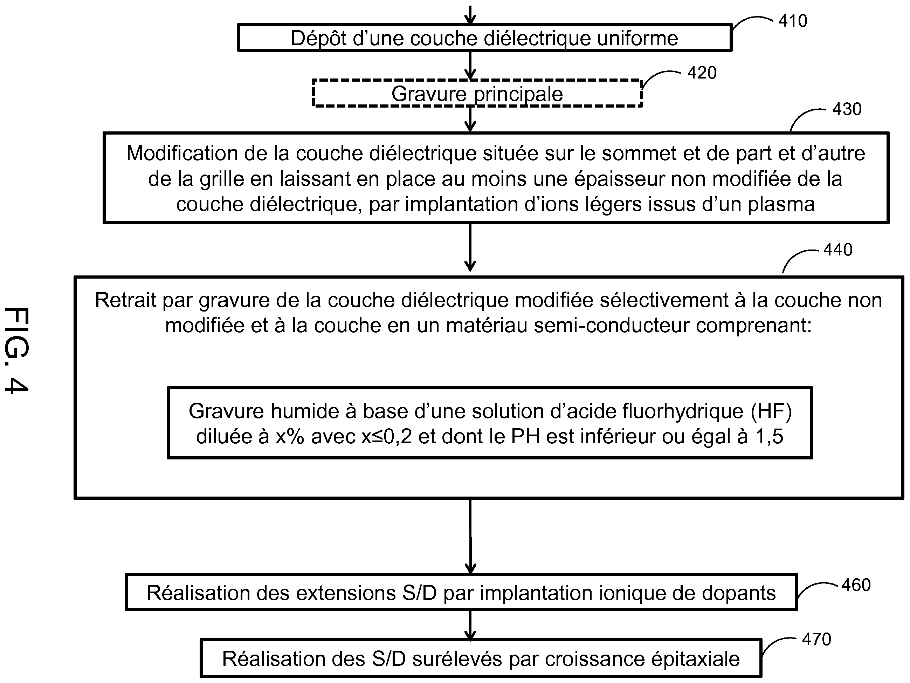

La **figure 4** résume les étapes du procédé de l'invention destinées à former des espaceurs et qui n'induisent peu ou aucun des défauts décrits notamment dans les figures 1b, 1c et 1d pour la réalisation de transistors, par exemple mais non limitativement de type FDSOI.

Après dépôt 410 par LPCVD d'une couche diélectrique 152 uniforme sur toutes les surfaces des dispositifs en cours de fabrication, on procède au retrait de ladite couche diélectrique modifiée 158 sur les surfaces qui ne sont pas destinées à former les espaceurs. Ce retrait comprend plusieurs étapes, dont les étapes 430, 440 et optionnellement l'étape 420 préalable.

Ainsi, optionnellement, on procède à une gravure « principale », de préférence une gravure humide conventionnelle isotrope 420 de la couche diélectrique modifiée 158. Dans le cadre de mises en oeuvre spécifiques de l'invention, on peut décider de maintenir ou non l'étape de gravure principale 420, les étapes suivantes s'appliquent alors soit sur la couche diélectrique 152 telle que déposée ou sur la couche restante après qu'une gravure principale a été préalablement effectuée comme dans le procédé standard de gravure des espaceurs.

Comme montré sur la figure 2b, l'étape suivante 430 consiste à modifier de façon anisotrope tout ou partie 154 de la couche diélectrique restante 152 par implantation d'ions légers.

Suivant les applications du procédé de l'invention on pourra préférer utiliser un graveur plasma pour l'implantation plasma notamment pour les raisons suivantes : le coût de l'appareillage est moins élevé, les temps de cycle de fabrication peuvent être plus courts puisque l'étape de gravure principale 420 et celle de modification 430 de la couche diélectrique 152 peuvent alors se faire dans le même appareillage sans remise à l'air des dispositifs en cours de fabrication. On notera en particulier que l'étape de modification 430 peut se pratiquer de nombreuses façons différentes en adaptant toutes sortes de moyens couramment employés par l'industrie de la microélectronique, tel qu'à l'aide de tout type graveur, par exemple dans un réacteur ICP de l'anglais « Inductively Coupled Plasma » c'est-à-dire « plasma à couplage inductif », ou dans un réacteur de type CCP de l'anglais « Capacitively Coupled Plasma » c'est-à-dire « plasma à couplage capacitif » qui permet de contrôler l'énergie des ions. On peut aussi utiliser un type de plasma dit par immersion couramment utilisé pour pratiquer une implantation d'espèces en surface d'un dispositif en cours de fabrication.

Pour choisir les paramètres d'implantation l'homme du métier, afin de déterminer le comportement du matériau à graver dans le type de graveur plasma choisi, procédera préalablement de préférence à des essais « pleine plaque » afin d'établir des courbes de comportement. Il en déduira les paramètres de l'implantation, en particulier l'énergie et la dose d'ions, c'est-à-dire le temps d'exposition, à utiliser pour atteindre l'épaisseur voulue de matériau à modifier.

Le tableau ci-après donne des conditions typiques de mise en oeuvre de l'étape 430 de modification de la couche diélectrique 152 dans le cas d'utilisation d'un réacteur de gravure plasma standard. Ces conditions sont largement dépendantes de l'épaisseur à modifier dans la couche diélectrique 152. Ceci n'est qu'un exemple particulier de mise en oeuvre de l'étape 430 de modification de la couche à graver.

La possibilité de pulser la source et/ou le bias permet également d'avoir un meilleur contrôle sur la profondeur d'implantation pour de faibles épaisseurs.

| | |
|---|---|
| Réacteur de gravure : | Les valeurs ci-dessous s'appliquent plus particulièrement au type de graveur ICP bien que n'importe quel type de dispositif de gravure humide est potentiellement utilisable. |
| Épaisseur modifiée : | de 1 nanomètre à quelques dizaines de nanomètres, typiquement 10 nanomètres. |
| Chimie | basée sur une chimie à base d'hydrogène et/ou à base d'hélium telle que H2, NH3 ou une combinaison d'hélium et d'hydrogène, ou d'hélium et de NH3. |
| Débit composant : | |
| - H2 | 10 sccm - 500 sccm (centimètres cube par minute) |
| - He | 50 sccm - 500 sccm |
| - NH3 | 10 sccm - 500 sccm |
| Puissance de la source : | 0 - 2000 W |
| Tension de polarisation : | 20 V - 500 V |
| Fréquence | 100 Hz - 500 kHz (pour le mode pulsé) |
| Cycle opératoire | 1 0 % - 90% (pour le mode pulsé) |
| Pression: | 5 milli - 100 milli Torr |
| Température : | 10 °C - 100°C |
| Temps : | quelques secondes à quelques centaines de secondes |

L'étape suivante 440 est celle où l'on pratique le retrait par gravure de la couche modifiée ou tout au moins de l'épaisseur modifiée de la couche diélectrique modifiée 158. Pour éviter les problèmes des procédés traditionnels de gravure des espaceurs décrits dans les figures 1b à 1d, il est nécessaire que la gravure de la couche diélectrique modifiée 158 soit la plus sélective possible par rapport au silicium notamment afin de ne pas attaquer le silicium monocristallin des zones source/drain avec les inconvénients et conséquences décrits précédemment.

Le retrait 440 de la couche diélectrique modifiée 158 comprend la gravure humide à base d'une solution comprenant du HF et dont le pH est inférieur à 1.7.

L'épaisseur de la couche diélectrique modifiée 158 est typiquement comprise dans une gamme de valeurs allant de 1 nanomètre à quelques dizaines de nanomètres. Les temps de gravure peuvent aller de quelques secondes à quelques minutes. Ils sont évidemment directement dépendants de l'épaisseur de la couche diélectrique qui a été modifiée 158.

Les étapes suivantes 460, 470 du procédé ne sont pas différentes de celles correspondantes des procédés standard où l'on réalise possiblement les extensions des zones source/drain 460 par implantation ionique de dopants avant croissance épitaxiale des source/drain surélevés 470 de transistors par exemple de type FDSOI.

### Exemple détaillé non limitatif

A titre d'exemple non limitatif de l'invention, on dépose une couche de nitrure de silicium (SiN) de 15nm destinée à former un espaceur 125.

Pour modifier une épaisseur de 12 nm de nitrure de silicium dans un graveur de type ICP (TCP RF), en continu, on applique une tension de 250V (tension de polarisation) pendant une durée de 60 secondes pour un plasma formé à partir d'un composant à base d'hydrogène (H) dont le débit est de 48 sccm. Dans ce cas, la pression utilisée est de 10 mTorr et la puissance de la source de 500W.

Par exemple pour retirer 10nm de SiN modifié, on expose ce dernier à une solution de HF diluée à 0.1% dont le pH est de 0.93 pendant 12 minutes (720 secondes).

Au vu de la description qui précède, il ressort clairement que l'invention permet non seulement un contrôle des dommages pouvant être engendrés suite à une implantation ionique, mais également une amélioration du retrait de la couche diélectrique modifiée 152, en proposant un procédé présentant une meilleure sélectivité de gravure entre la couche diélectrique modifiée et la couche diélectrique non modifiée d'une part, entre la couche diélectrique modifiée et la couche en oxyde de silicium et entre la couche diélectrique modifiée et la couche en un matériau semi-conducteur d'autre part.

Avantageusement, la présente invention propose une sélectivité infinie de la couche diélectrique modifiée. Ainsi, la présente invention permet un meilleur contrôle des dimensions critiques. Le procédé selon la présente invention permet en outre une gravure sélective de la couche diélectrique modifiée au regard d'autres couches non modifiées, évitant tout risque de consommer tout ou partie d'une couche à base de nitrure de silicium ou une couche à base d'oxyde de silicium. En particulier le masque dur recouvrant la grille et les tranchées d'isolation en oxyde silicium ne sont pas altérées par la gravure des espaceurs.

L'invention n'est pas limitée aux seuls modes et exemples de réalisation décrits ci-dessus, mais s'étend à tous les modes de réalisation entrant dans la portée des revendications.

## Revendications

1. Procédé de formation d'espaceurs (150) d'une grille (120) d'un transistor à effet de champ (100), la grille (120) comprenant des flancs (125) et un sommet (126) et étant située au-dessus d'une couche (146) en un matériau semi-conducteur, le procédé comprenant une étape (410) de formation d'une couche diélectrique (152) recouvrant la grille du transistor, le procédé comprenant :
- après l'étape de formation de la couche diélectrique (152), au moins une étape de modification (430) de ladite couche diélectrique (152) par implantation d'ions au moins dans des portions de la couche diélectrique (152) qui sont situées sur un sommet (126) de la grille et de part et d'autre de la grille (120) et qui sont perpendiculaires aux flancs (125) de la grille (120) en conservant des portions de la couche diélectrique (152) recouvrant les flancs (125) de la grille (120) non-modifiées ou non-modifiées sur toute leur épaisseur; les ions étant des ions à base d'hydrogène (H) et/ou à base d'hélium (He);
- au moins une étape de retrait (440) de la couche diélectrique modifiée à l'aide d'une gravure sélective de ladite couche diélectrique modifiée vis-à-vis de la couche (146) en un matériau semi-conducteur et vis-à-vis de la couche diélectrique (152) non modifiée ;
**caractérisé en ce que** la couche diélectrique (152) est en un matériau pris parmi : un nitrure de silicium, SiC, SiCN, SiCBN, et **en ce que** ladite gravure sélective de la couche diélectrique modifiée comprend une gravure humide à base d'une solution comprenant de l'acide fluorhydrique (HF) diluée à x% en masse, avec x≤0.2 et présentant un pH inférieur ou égal à 1.5.

2. Procédé selon la revendication précédente dans lequel le pH est inférieur ou égal à 1.3, de préférence inférieur ou égal à 1 et de préférence strictement inférieur à 1.

3. Procédé selon l'une quelconque des revendications précédentes dans lequel x≤0.15 et de préférence x≤0.1.

4. Procédé selon l'une quelconque des revendications précédentes dans lequel x est sensiblement égal à 0.1.

5. Procédé selon l'une quelconque des revendications précédentes dans lequel la solution est obtenue par ajout d'au moins l'un parmi : acide chlorhydrique (HCl), acide sulfurique H₂SO₄, acide nitrique HNO₃.

6. Procédé selon l'une quelconque des revendications précédentes dans lequel la gravure sélective de ladite couche diélectrique modifiée vis-à-vis de la couche diélectrique (152) non modifiée présente une sélectivité supérieure ou à égale à 11.

7. Procédé selon l'une quelconque des revendications précédentes comprenant, avant l'étape de retrait (440) une étape de formation d'un masque (124) situé sur le sommet (126) de la grille (120), ledit masque étant à base d'oxyde de silicium SiOy y étant un entier supérieur ou égal à 1, et de préférence à base de dioxyde de silicium (SiO2).

8. Procédé selon l'une quelconque des revendications précédentes comprenant, avant l'étape de retrait (440) une étape de formation d'une tranchée d'isolation (117) s'étendant à travers la couche (146) en un matériau semi-conducteur, ladite tranchée d'isolation (117) étant à base d'oxyde de silicium SiOy, y étant un entier supérieur ou égal à 1, et de préférence à base de dioxyde de silicium (SiO2).

9. Procédé selon l'une quelconque des deux revendications précédentes dans lequel la gravure sélective de ladite couche diélectrique modifiée vis-à-vis de l'oxyde de silicium SiOy présente une sélectivité supérieure ou égale à 33.

10. Procédé selon l'une quelconque des revendications précédentes comprenant une unique étape de modification (430) effectuée de sorte à modifier la couche diélectrique (152) dans toute son épaisseur sur toutes les surfaces parallèles au plan d'un substrat sur lequel repose la grille (120) et à ne pas modifier la couche diélectrique (152) dans toute son épaisseur sur les surfaces perpendiculaires à ce plan.

11. Procédé selon l'une quelconque des revendications précédentes, dans lequel l'étape de modification (430) de ladite couche diélectrique (152) par implantation d'ions comprend la mise en présence de la couche diélectrique (152) avec un plasma créant une implantation anisotrope d'ions selon une direction privilégiée parallèle à des flancs (125) de la grille (120).

12. Procédé selon l'une quelconque des revendications précédentes, dans lequel les ions sont des ions à base d'hydrogène (H) et/ou à base d'hélium (He).

13. Procédé selon l'une quelconque des revendications précédentes, dans lequel le plasma est obtenu par injection dans un réacteur de gaz notamment pris parmi l'hélium (He), l'hydrogène (H2) et l'ammoniac (NH3) le débit d'injection de ces gaz étant respectivement de 50 à 500 sccm, 10 à 500sccm, 10 à 500 sccm.

14. Procédé selon l'une quelconque des revendications précédentes dans lequel l'étape de modification (430) de la couche diélectrique (152) est réalisée avec une puissance de polarisation ou puissance de source comprise entre 20V (volt) et 500V, avec une pression comprise entre 5 mTorr (milliTorr) et 100 mTorr, à une température comprise entre 10°C et 100°C, pendant une durée de quelques secondes à quelques centaines de secondes.

15. Procédé selon l'une quelconque des revendications précédentes, dans lequel le transistor est un transistor de type FDSOI ou de type FinFET.

## Patentansprüche

1. Verfahren zum Bilden von Abstandshaltern (150) eines Gates (120) eines Feldeffekttransistors (100), wobei das Gate (120) Flanken (125) und eine Spitze (126) umfasst und sich über einer Schicht (146) aus einem Halbleitermaterial befindet, wobei das Verfahren einen Schritt (410) des Bildens einer dielektrischen Schicht (152) umfasst, die das Gate des Transistors bedeckt, wobei das Verfahren umfasst:
- nach dem Schritt des Bildens der dielektrischen Schicht (152), mindestens einen Schritt des Modifizierens (430) der dielektrischen Schicht (152) durch Ionenimplantation mindestens in Abschnitten der dielektrischen Schicht (152), die sich an einer Spitze (126) des Gates und auf beiden Seiten des Gates (120) befinden und die zu den Flanken (125) des Gates (120) senkrecht sind, wobei Abschnitte der dielektrischen Schicht (152), die die Flanken (125) des Gates (120) bedecken, unmodifiziert oder in ihrer gesamten Dicke unmodifiziert belassen werden; wobei es sich bei den Ionen um Ionen auf Basis von Wasserstoff (H) und/oder auf Basis von Helium (He) handelt;
- mindestens einen Schritt des Entfernens (440) der modifizierten dielektrischen Schicht mit Hilfe eines gegenüber der Schicht (146) aus einem Halbleitermaterial und gegenüber der unmodifizierten dielektrische Schicht (152) selektiven Ätzens der modifizierten dielektrischen Schicht;
**dadurch gekennzeichnet, dass** die dielektrische Schicht (152) aus einem Material ist, ausgewählt aus: einem Siliciumnitrid, SiC, SiCN, SiCBN, und dadurch, dass das selektive Ätzen der modifizierten dielektrischen Schicht ein Nassätzen auf Basis einer Lösung umfasst, die auf x Masse-% verdünnte Fluorwasserstoff- (HF) Säure umfasst, wobei x ≤ 0,2, und einen pH-Wert von kleiner oder gleich 1,5 aufweist.

2. Verfahren nach dem vorstehenden Anspruch, wobei der pH-Wert kleiner oder gleich 1,3, vorzugsweise kleiner oder gleich 1, und vorzugsweise streng kleiner als 1 ist.

3. Verfahren nach einem der vorstehenden Ansprüche, wobei x ≤ 0,15, und vorzugsweise x ≤ 0,1.

4. Verfahren nach einem der vorstehenden Ansprüche, wobei x im Wesentlichen gleich 0,1 ist.

5. Verfahren nach einem der vorstehenden Ansprüche, wobei die Lösung durch Zugabe von mindestens einem erhalten wird aus: Chlorwasserstoffsäure (HCl), Schwefelsäure H₂SO₄, Salpetersäure HNO₃.

6. Verfahren nach einem der vorstehenden Ansprüche, wobei das gegenüber der unmodifizierten dielektrischen Schicht (152) selektive Ätzen der modifizierten dielektrischen Schicht eine Selektivität von größer oder gleich 11 aufweist.

7. Verfahren nach einem der vorstehenden Ansprüche, das vor dem Schritt des Entfernens (440) einen Schritt des Bildens einer Maske (124) umfasst, die sich an der Spitze (126) des Gates (120) befindet, wobei die Maske auf Basis von Siliciumoxid SiOy, wobei y eine ganze Zahl von größer oder gleich 1 ist, und vorzugsweise auf Basis von Siliciumdioxid (SiO2) ist.

8. Verfahren nach einem der vorstehenden Ansprüche, das vor dem Schritt des Entfernens (440) einen Schritt des Bildens eines Isoliergrabens (117) umfasst, der sich durch die Schicht (146) aus einem Halbleitermaterial erstreckt, wobei der Isoliergraben (117) auf Basis von Siliciumoxid SiOy, wobei y eine ganze Zahl von größer oder gleich 1 ist, und vorzugsweise auf Basis von Siliciumdioxid (SiO2) ist.

9. Verfahren nach einem der zwei vorstehenden Ansprüche, wobei das gegenüber dem Siliciumoxid SiOy selektive Ätzen der modifizierten dielektrischen Schicht eine Selektivität von größer oder gleich 33 aufweist.

10. Verfahren nach einem der vorstehenden Ansprüche, das einen einzigen Schritt des Modifizierens (430) umfasst, der vorgenommen wird, um die dielektrische Schicht (152) an allen den Flächen, die zur Ebene eines Substrats, auf dem das Gate (120) aufliegt, parallel sind, in ihrer gesamten Dicke zu modifizieren, und um die dielektrische Schicht (152) an den Flächen, die zu dieser Ebene senkrecht sind, in ihrer gesamten Dicke nicht zu modifizieren.

11. Verfahren nach einem der vorstehenden Ansprüche, wobei der Schritt des Modifizierens (430) der dielektrischen Schicht (152) durch Ionenimplantation das Inkontaktbringen der dielektrischen Schicht (152) mit einem Plasma umfasst, das eine anisotrope Ionenimplantation gemäß einer bevorzugten Richtung erzeugt, die zu Flanken (125) des Gates (120) parallel ist.

12. Verfahren nach einem der vorstehenden Ansprüche, wobei es sich bei den Ionen um Ionen auf Basis von Wasserstoff (H) und/oder auf Basis von Helium (He) handelt.

13. Verfahren nach einem der vorstehenden Ansprüche, wobei das Plasma durch Einspritzen von Gas, insbesondere ausgewählt aus Helium (He), Wasserstoff (H2) und Ammoniak (NH3), in einen Reaktor erhalten wird, wobei die Einspritzrate dieser Gase jeweils 50 bis 500 sccm, 10 bis 500 sccm, 10 bis 500 sccm beträgt.

14. Verfahren nach einem der vorstehenden Ansprüche, wobei der Schritt des Modifizierens (430) der dielektrischen Schicht (152) mit einer Vorspannungsleistung oder Quellenleistung im Bereich zwischen 20 V (Volt) und 500 V, mit einem Druck im Bereich zwischen 5 mTorr (Millitorr) und 100 mTorr, bei einer Temperatur im Bereich zwischen 10 °C und 100 °C, während eine Dauer von einigen Sekunden bis einigen Hundertstelsekunden ausgeführt wird.

15. Verfahren nach einem der vorstehenden Ansprüche, wobei es sich beim Transistor um einen Transistor vom Typ FDSOI oder vom Typ FinFET handelt.

## Claims

1. Method for forming spacers (150) of a gate (120) of a field effect transistor (100), the gate (120) comprising sides (125) and a top (126) and being situated above a layer (146) made from a semiconductor material, the method comprising a step (410) of forming a dielectric layer (152) covering the transistor gate, the method comprising:
- after the step of forming the dielectric layer (152), at least one step (430) of modifying said dielectric layer (152) by implanting ions at least in portions of the dielectric layer (152) that are situated on a top (126) of the gate and either side of the gate (120) and which are perpendicular to the sides (125) of the gate (120) while keeping portions of the dielectric layer (152) covering the sides (125) of the gate (120) non-modified or non-modified over their entire thickness; the ions being ions based on hydrogen (H) and/or based on helium (He);
- at least one step (440) of removing the modified dielectric layer by means of a selective etching of said modified dielectric layer vis-à-vis the layer (146) made from a semiconductor material and vis-à-vis the non-modified dielectric layer (152);
**characterised in that** the dielectric layer (152) is made from a material taken from among: a silicon nitride, SiC, SiCN, SiCBN, and **in that** said selective etching of the modified dielectric layer comprises a wet etching using a solution comprising hydrofluoric acid (HF) diluted to x% by mass, with x ≤ 0.2 and having a pH of less than or equal to 1.5.

2. Method according to the preceding claim, wherein the pH is less than or equal to 1.3, preferably less than or equal to 1 and preferably strictly less than 1.

3. Method according to either one of the preceding claims, wherein x ≤ 0.15 and preferably x ≤ 0.1.

4. Method according to any one of the preceding claims, wherein x is substantially equal to 0.1.

5. Method according to any one of the preceding claims, wherein the solution is obtained by adding at least one from among: hydrochloric acid (HCl), sulphuric acid H₂SO₄, nitric acid HNO₃.

6. Method according to any one of the preceding claims, wherein the selective etching of said modified dielectric layer vis-à-vis the non-modified dielectric layer (152) has a selectivity greater than or equal to 11.

7. Method according to any one of the preceding claims, comprising, before the removal step (440), a step of forming a mask (124) situated on the top (126) of the gate (120), said mask being based on silicon oxide SiO_{y}, y being an integer greater than or equal to 1, and preferably based on silicon dioxide (SiO₂).

8. Method according to any one of the preceding claims, comprising, before the removal step (440), a step of forming an isolation trench (117) extending through the layer (146) made from a semiconductor material, said isolation trench (117) being based on silicon oxide SiO_{y}, y being an integer greater than or equal to 1, and preferably based on silicon dioxide (SiO₂).

9. Method according to either one of the preceding two claims, wherein the selective etching of said modified dielectric layer vis-à-vis the silicon oxide SiO_{y} has a selectivity greater than or equal to 33.

10. Method according to any one of the preceding claims, comprising a single modification step (430) performed so as to modify the dielectric layer (152) throughout the thickness thereof over all the surfaces parallel to the plane of a substrate on which the gate (120) rests and so as to not modify the dielectric layer (152) throughout the thickness thereof on the surfaces perpendicular to this plane.

11. Method according to any one of the preceding claims, wherein the step (430) of modifying said dielectric layer (152) by implantation of ions comprises putting the dielectric layer (152) in the presence of a plasma creating an anisotropic implantation of ions in a privileged direction parallel to sides (125) of the gate (120).

12. Method according to any one of the preceding claims, wherein the ions are ions based on hydrogen (H) and/or based on helium (He).

13. Method according to any one of the preceding claims, wherein the plasma is obtained by injection in a reactor of gas in particular taken from among helium (He), hydrogen (H₂) and ammonia (NH₃), the rate of injection of these gases being respectively 50 to 500 sccm, 10 to 500 sccm, 10 to 500 sccm.

14. Method according to any one of the preceding claims, wherein the step (430) of modifying the dielectric layer (152) is performed with a polarisation power or source power of between 20 V (volts) and 500 V, with a pressure of between 5 mTorr (millitorr) and 100 mTorr, at a temperature of between 10°C and 100°C, for a period of a few seconds to a few hundreds of seconds.

15. Method according to any one of the preceding claims, wherein the transistor is an FDSOI or FinFET transistor.
